# EUROPEAN PATENT SPECIFICATION

(11) **EP 3 241 244 B1**
(45) Date of publication and mention of the grant of the patent: **11.09.2019**
(21) Application number: 15823750.3
(22) Date of filing: 15.12.2015
(51) Int. Cl.: H01L 31/049, H02S 30/20, H01L 31/0392

(54) **APPARATUS FOR SUPPORTING AND TRANSPORTING A PHOTOVOLTAIC SUB-MODULE DURING PROCESSING**
VORRICHTUNG ZUM TRAGEN UND TRANSPORTIEREN EINES FOTOVOLTAISCHEN SUBMODULS WÄHREND DER VERARBEITUNG
APPAREIL DE SUPPORT ET DE TRANSPORT D'UN SOUS-MODULE PHOTOVOLTAÏQUE PENDANT LE TRAITEMENT

(30) Priority: 30.12.2014 US 201462097618 P; 30.12.2014 WO PCT/EP2014/025030
(43) Date of publication of application: 08.11.2017
(73) Proprietor: Flisom AG, 8155 Niederhasli (CH)
(72) Inventor: OLDRIDGE, John, Canterbury 7630 (NZ); KERN, Roland, 8180 Buelach (CH)
(74) Representative: Parrini, Lorenzo
(86) International application number: PCT/IB2015/002353
(87) International publication number: WO 2016/108079

(56) References cited:
- WO-A1-2010/021614
- WO-A1-2014/062135
- US-A- 5 968 287
- US-A1- 2011 308 563
- US-A1- 2012 017 980

## Description

### BACKGROUND

### Field

The present disclosure relates to photovoltaic modules and methods of forming the same.

### Description of the Related Art

Solar cells are photovoltaic devices that convert sunlight directly into electrical power. Most conventionally formed solar cells have a conversion efficiency of about 22% or less. Because the amortized cost of solar cell-based installations for generating photovoltaic electricity may be higher than the cost of generating electricity using traditional methods, there has been an effort to increase the efficiency of the formed solar cells and an effort to reduce the cost required to manufacture solar cell containing devices, such as photovoltaic modules. The cost required to form solar cells and photovoltaic modules can be improved by reducing solar cell and photovoltaic module manufacturing costs, reducing solar cell and photovoltaic module component part costs and improving the solar cell's and/or the photovoltaic module's manufacturing process yield.

A thin-film solar cell, also called a thin-film photovoltaic cell, is a type of solar cell that is made by depositing one or more thin layers on a supporting substrate. Thin-film solar cells are commercially used in several solar cell technologies, including cadmium telluride (CdTe), copper indium gallium group 13 of the periodic table including In, Ga, or Al, and C represents elements in group 16 of the periodic table including S, Se, or Te.

Thin-film photovoltaic cells, such as Cu (In, Ga) Se₂ (CIGS) or CdTe-based photovoltaic cells, show a high potential for cheaper solar electricity, lower energy payback time, and improved life cycle impact as compared to traditional wafer based silicon photovoltaic cells. A thin-film solar cell generally includes a portion of the one or more thin-film layers, which are formed on a substrate, by dividing the one or more thin-film layers into area sections that are then electrically interconnected to each other during the dividing process (e.g., scribing process) or by other connection means. A substrate that contains an array of interconnected thin-film solar cells is typically called a sub-module. The sub-modules each may generate a specific amount of electric power and are typically tiled into an array of interconnected sub-modules, which are typically called a photovoltaic module. A photovoltaic module is generally sized to deliver a desired amount of generated electrical power when the solar cells in the sub-modules in the photovoltaic module are exposed to sunlight.

US 5 968 287 discloses for example a photovoltaic building structure comprising a number of interlockable building panels. US 2011/0308563 A1 discloses a roll for fabricating a photovoltaic (PV) array including a flexible continuous backside sheet, a transparent flexible continuous frontside sheet, a row of individually sealed PV modules extending along the length of the roll and including at least two PV modules disposed between the backside sheet and the frontside sheet.

In conventional photovoltaic modules, the supporting structures of the photovoltaic module can account for a large portion of the production cost of the photovoltaic module. One common supporting structure material found in conventional photovoltaic modules is glass, which can be used in a sheet form, and can be as costly to produce as the photovoltaic materials disposed thereon. Therefore, it is desirable to form a sub-module that contains a substrate that is relatively inexpensive to produce and also can be used in places where conventional sub-modules that contain conventional substrates, such as glass substrates, cannot be used.

In some applications, the substrate on which the thin-film layers are formed is made from a thin and flexible material that has a lower production cost than more conventional substrate materials. However, in some cases the flexible substrates, such as polymeric material containing substrates, and/or layers formed thereon tend to absorb water from the environment and/or tend to naturally deform, from a desirable regular flat planar shape, due to stresses formed in the deposited thin-film layers. The absorption of water by the substrate and/or layers formed thereon can subsequently affect the solar cell and/or photovoltaic module forming process, due to the contaminating effect that the absorbed water has on the thin-film layer deposition processes and the effect that the water trapped in the formed photovoltaic module can have on the ability of the formed photovoltaic module's ability to pass certification tests used to determine the effective life-time of the complete photovoltaic module. Also, the deformation or distortion of the sub-modules during the photovoltaic module forming process can damage the sub-module and affect the sub-module interconnection process and placement requirements in the photovoltaic module.

In general, the sub-modules formed on a large roll of a flexible substrate material must at some point be cut in the cross-web direction to singulate them before placement in a string consisting of, for example, 3-6 sub-modules. Between the cutting from the roll and sub-module interconnection steps (i.e., stringing steps), the sub-modules must be further prepared, tested and sorted individually into individual groups based on electrical performance, such that the finally interconnected sub-modules in the photovoltaic module will include only sub-modules from a specific performance group. However, the handling of large area, thin, and flexible photovoltaic sub-modules after being cut from the roll of material can be problematic due to the fragile nature of the materials disposed thereon. Conventional processing techniques included the use of a separate substrate that included an adhesive layer that was used to temporarily hold the sub-modules. However, the use of an adhesive roll has two major drawbacks, which include: 1) the carrier film can only be used once, which adds to the product cost, and 2) remnants of the adhesive may be left on the back-side of the sub-modules, which can affect photovoltaic module performance over time.

Therefore, there is a need for an apparatus and method for supporting a fragile and flexible photovoltaic sub-module during the manufacturing process used to form a photovoltaic module. There is also a need for an apparatus and method for minimizing the uncontrolled deformation of the sub-module during the photovoltaic module forming processes. There is also a need for a handling and storage apparatus that protects the thin-film layer surface of the sub-module from being contacted, for example by handling personnel. Moreover, there is also a need for an apparatus and method that is able to minimize the amount of gas or water absorption on the sub-module in between photovoltaic module processing steps, and an apparatus and method that is able to solve some of the other problems described above.

### SUMMARY

Embodiments of the present disclosure provide an apparatus and method for forming a sub-module retaining assembly that is used to support and store multiple solar cell containing sub-module assemblies, or also referred to herein as sub-modules, during different stages of a photovoltaic module formation process.

The present invention provides a photovoltaic sub-module retaining assembly according to claim 1.

The invention also provides a photovoltaic sub-module positioning device according to claim 5.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of the scope of the invention, which is defined by the claims.
Figure 1A is an isometric view of a sub-module retaining assembly, according to an embodiment of the present disclosure.
Figure 1B is a side cross-sectional view of a portion of the sub-module retaining assembly as viewed along the section line 1B-1B in Figure 1A.
Figure 2 is a side cross-sectional view of a portion of the sub-module retaining assembly as viewed along the section line 2-2 in Figure 1A.
Figure 3 is an isometric view of a sub-module retaining assembly disposed on transport assembly, according to an embodiment of the present disclosure.
Figure 4 is an isometric view of a sub-module retaining assembly disposed on transport assembly, according to another embodiment of the present disclosure.
Figure 5 is a side cross-sectional view of a portion of the sub-module retaining assembly and transport assembly, according to an embodiment of the present disclosure.
Figure 6 is an isometric view of a vacuum support assembly disposed in a vacuum distribution system, according to another embodiment of the present disclosure.
Figure 7 is a side cross-sectional view of a photovoltaic sub-module positioning device, according to another embodiment of the present disclosure.
Figure 8 is a side cross-sectional view of a photovoltaic sub-module positioning device, according to another embodiment of the present disclosure.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present disclosure provide an apparatus and method for forming a sub-module retaining assembly that is used to support and store multiple solar cell containing sub-module assemblies, or also referred to herein as sub-modules or photovoltaic sub-modules, during different stages of a photovoltaic module formation process. The sub-module retaining assembly is generally designed to retain fragile flexible photovoltaic sub-modules so that they will not become undesirably and uncontrollably deformed, due to intrinsic stresses found in the formed flexible photovoltaic sub-modules or other handling related forces. The sub-module retaining assembly also provides a handling and storage apparatus that protects the thin-film layer surface from being contacted, for example by handling personnel. The sub-module retaining assembly also allows any absorbed or adsorbed water received by exposure to the atmospheric environment to be easily and rapidly removed from the stored sub-modules by placing them in a vacuum environment before, during or after various photovoltaic module formation steps. Embodiments of the present disclosure may further provide an apparatus and method for supporting and positioning the sub-module retaining assembly such that sub-modules can be transferred from or positioned within the sub-module retaining assembly during different phases of the photovoltaic module formation process. Protecting non-encapsulated sub-modules from unwanted deformation or potentially corrosive chemicals found in the environment lengthens the shelf life of non-encapsulated modules and can also improve the usable photovoltaic module lifetime after their encapsulation.

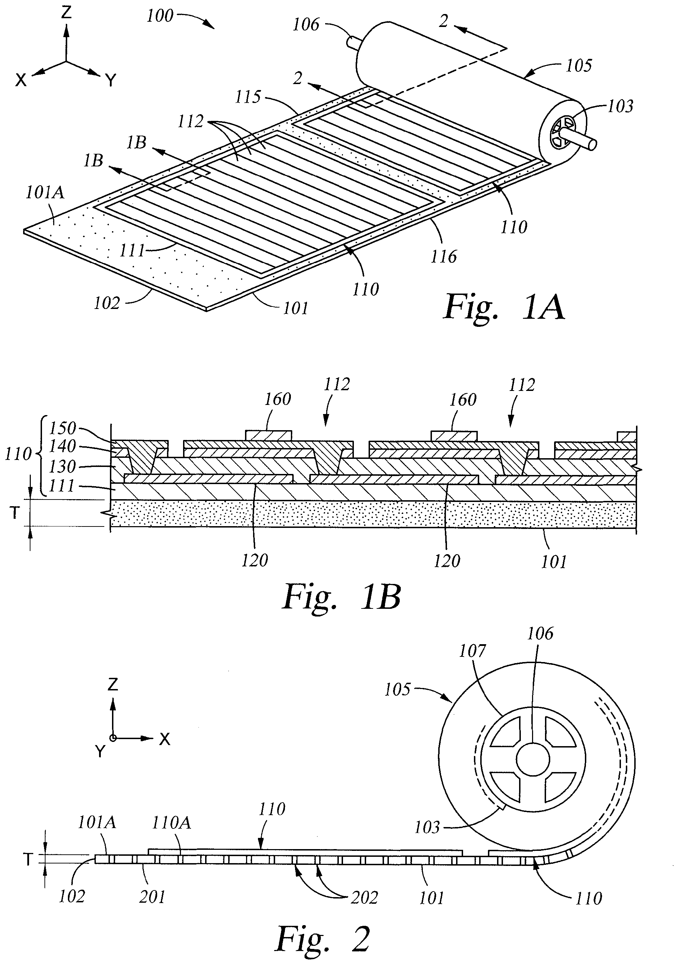

Figure 1A is an isometric view of a sub-module retaining assembly 100 that includes a carrier film 101 (also referred to as porous carrier film) and one or more flexible photovoltaic sub-modules 110, which is also referred to hereafter as sub-modules 110, that are disposed on a surface 101A (first surface) of the carrier film 101. The following generally describes embodiments including a plurality of flexible photovoltaic sub-modules 110, but some embodiments may include only one flexible photovoltaic sub-module 110. Figure 1B is a side cross-sectional view of a portion of the sub-module retaining assembly 100 as viewed from the section line 1B-1B shown in Figure 1A. Figure 2 is a side cross-sectional view of a portion of the sub-module retaining assembly 100 as viewed from the section line 2-2 shown in Figure 1A.

At least one of the plurality of flexible photovoltaic sub-modules 110 on the supporting carrier film 101 is wound around a supporting hub 107 having a central axis to form a sub-module roll 105 (e.g., first sub-module roll). The often fragile and flexible photovoltaic sub-modules 110 can thus be held in place by a compression force applied between neighboring layers of the carrier film 101 when they are wound around the supporting hub 107. This compact and protective winding apparatus using a carrier film 101 is therefore especially beneficial for storage, improved shelf life, transportation, and handling of sub-modules 110 wound with the carrier film 101. In this configuration, the carrier film 101 may have a first end 103 that is coupled to the supporting hub 107 and a second end 102, wherein the plurality of flexible photovoltaic sub-modules 110 are disposed in an arrangement on the surface 101A of the carrier film 101 between the first end 103 and the second end 102. The arrangement of flexible photovoltaic sub-modules 110 are arranged in a spaced apart pattern, such that when the flexible photovoltaic sub-modules 110 are disposed on the surface 101A they do not touch each other. However, this configuration is not intended to be limiting as to the scope of the disclosure provided herein, since the flexible photovoltaic sub-modules 110 may be disposed in other arrangements, such as an at least partially overlapping arrangement.

In some configurations, the supporting hub 107 may also contain an axle 106 that is disposed along a central axis of the supporting hub 107. The axle 106 can be used to support the sub-module roll 105 during different phases of the photovoltaic module forming process.

The flexible photovoltaic sub-modules 110 generally include a plurality of solar cells 112 that are formed on a flexible substrate 111. The plurality of solar cells 112 may each be a thin-film type solar cell that includes a plurality of thin-film layers, which are formed on the flexible substrate 111. Referring to Figure 1B, the thin-film type solar cell may include an electrically conductive layer 120, an absorber layer 130, an optional buffer layer 140, a transparent conductive layer 150 and an optional front-contact metallized grid 160, which are all disposed on the flexible substrate 111. In some embodiments, the flexible substrate 111 may include a potassium-nondiffusing substrate material. However, in other embodiments, the flexible substrate 111 may generally be formed from a flexible material, such as coated metal, plastic-coated metal, polymeric, plastic, coated plastic such as metal-coated plastic, or flexible glass.

In one example, the flexible substrate material is a polyimide material. Polyimide is a flexible material that will not degrade at the temperatures required to deposit one or more of the thin-film solar cell layers using techniques, such as a physical vapor deposition technique (e.g., vacuum evaporation). Polyimide substrate materials also require less processing than metal substrates to form a flexible photovoltaic sub-module, and exhibit thermal expansion coefficients that are more compatible with the thermal expansion coefficients of material layers deposited on the substrate. Industrially available polyimide substrates are available, for example, in thicknesses ranging from 7 µm to 150 µm. While not intending to limit the scope of the disclosure provided herein, in one example, the flexible photovoltaic sub-modules 110 can have a length (X-direction) from about 1 cm to about 1000 cm, such as from about 5 cm to about 500 cm, such as from about 20 cm to about 160 cm and a width (Y-direction) from about 1 cm to about 200 cm, such as from about 10 cm to about 100 cm, such as from about 75 cm to about 85 cm.

In some embodiments, the supporting hub 107 has a cylindrical shape, which has a supporting hub length (Y-direction) that is at least as long as the width (Y-direction) of the carrier film 101, and the supporting hub 107 can have a diameter from about 15 mm to about 300 mm, such as about 150 mm. It is believed that supporting hub diameters from about 140 mm to about 200 mm are desirable to assure that the curvature of the thin-film containing sub-modules 110 disposed within the sub-module roll 105 will not induce a stress that will damage the thin-film layers formed on the flexible substrate 111. In some embodiments, it may be desirable to store the sub-modules 110 in a face-up orientation (exposing the thin-film coated side, as shown in Figure 1A) or a face-down orientation relative to the surface 101A of the carrier film 101 to further assure that either compressive or tensile stresses formed in the deposited thin-film layers formed on the flexible substrate 111 will not damage the formed solar cells 112, and/or the formed stresses can be compensated for by the bending of the sub-module 110, when the sub-module 110 is stored in a curved shape in the sub-module roll 105. In one example, where the deposited thin-film layers in the sub-modules 110 have a compressive intrinsic film stress formed therein, it may be desirable to store the sub-modules 110 so that the light receiving surface of the sub-modules 110 has a convex shape when wound within the sub-module roll 105.

The electrically conductive layer 120, also known as the back-contact layer, may be formed from a variety of electrically conductive materials, such as materials having a coefficient of thermal expansion (CTE) that is close to both the CTE of the flexible substrate 111 onto which it is deposited and to the CTE of other materials that are to be subsequently deposited upon it. The conductive layer 120 can have a high optical reflectance and may be made of, for example, molybdenum (Mo), although several other thin-film materials such as metal chalcogenides, molybdenum chalcogenides, molybdenum selenides (such as MoSe₂), sodium-doped (Na-doped) Mo, potassium-doped (K-doped) Mo, Na and K-doped Mo, transition metal chalcogenides, tin-doped indium oxide (ITO), doped or non-doped indium oxides, doped or non-doped zinc oxides, zirconium nitrides, tin oxides, titanium nitrides, W, Ta, Au, Ag, Cu, and Nb may also be used or included advantageously.

The absorber layer 130 may be made of an ABC composition material, wherein A represents elements in group 11 of the periodic table, as defined by the International Union of Pure and Applied Chemistry (e.g., Cu or Ag), B represents elements in group 13 of the periodic table (e.g., In, Ga, or Al), and C represents elements in group 16 of the periodic table (e.g., S, Se, or Te). An example of an ABC₂ material is the Cu(In,Ga)Se₂ semiconductor also known as CIGS.

Optionally, the thin-film solar cell includes at least one semiconductive buffer layer 140 that is formed on the absorber layer 130. The buffer layer 140 ordinarily has an energy bandgap higher than 1.5 eV, and is, for example, made of cadmium sulfide (CdS), cadmium sulfide hydroxides (Cd(S,OH)), cadmium zinc sulfides (CdZnS), indium sulfides, zinc sulfides, gallium selenides, indium selenides, compounds of (indium, gallium)-sulfur, compounds of (indium, gallium)-selenium, tin oxides, zinc oxides, compounds of zinc (magnesium, oxide)-sulfur, Zn(Mg,0)S, compounds of zinc (oxide, sulfur) materials, or variations thereof.

The transparent conductive layer 150, also known as the front-contact layer, ordinarily includes a transparent conductive oxide (TCO) layer, for example made of doped or non-doped variations of materials such as indium oxides, tin oxides, or zinc oxides.

Optionally, the front-contact metallized grid 160 may cover part of the transparent conductive layer 150 to advantageously augment front-contact conductivity. Also optionally, the thin-film photovoltaic device may be coated with at least one anti-reflective coating such as a thin material layer or an encapsulating film.

The carrier film 101 is generally formed from a durable and reusable porous material, which may have a plurality of holes or pores formed therethrough. The carrier film 101 may range in thickness of from about 5 µm to about 3 mm, such as from about 15 µm to about 1 mm. In one embodiment, the plurality of holes or pores are formed through a thickness T (Figure 1B) of the carrier film 101 allowing a gas to pass therethrough. The carrier film 101 can be at least about 3 mm wider in the Y-direction than the Y-direction size of the largest sub-module 110 to be disposed in the sub-module roll 105. A carrier film 101 may support multiple sub-modules 110, which are disposed on the surface 101A along the Y-direction. In one example, the carrier film's width may range, for small sub-modules, from about 4 cm to about 50 cm, for medium-sized sub-modules, from about 25 cm to about 100 cm, and for large sub-modules, from about 50 cm to about 200 cm.

The carrier film 101 may generally include a flexible material, such as a porous polymeric material, a porous metallic material, a plastic-coated porous metal, a porous plastic material, a porous paper, tissue paper, or other useful flexible porous material. The carrier film 101 may also include a getter material, for example a moisture getter. The getter material may for example line the sides of the carrier film 101, be impregnated in the carrier film 101, or form a layer on the carrier film 101, such as on the side that contacts the substrate of the sub-modules. In one embodiment, the carrier film 101 is formed of a structure including a porous material and a non-porous base material 201 that has a plurality of holes 202 formed therethrough. In one embodiment, the plurality of holes 202 may be formed in a regular or random pattern in the X-Y plane through the thickness T of the carrier film 101. In another embodiment, the plurality of holes may be a porous medium of interconnecting holes across the X-Y plane.

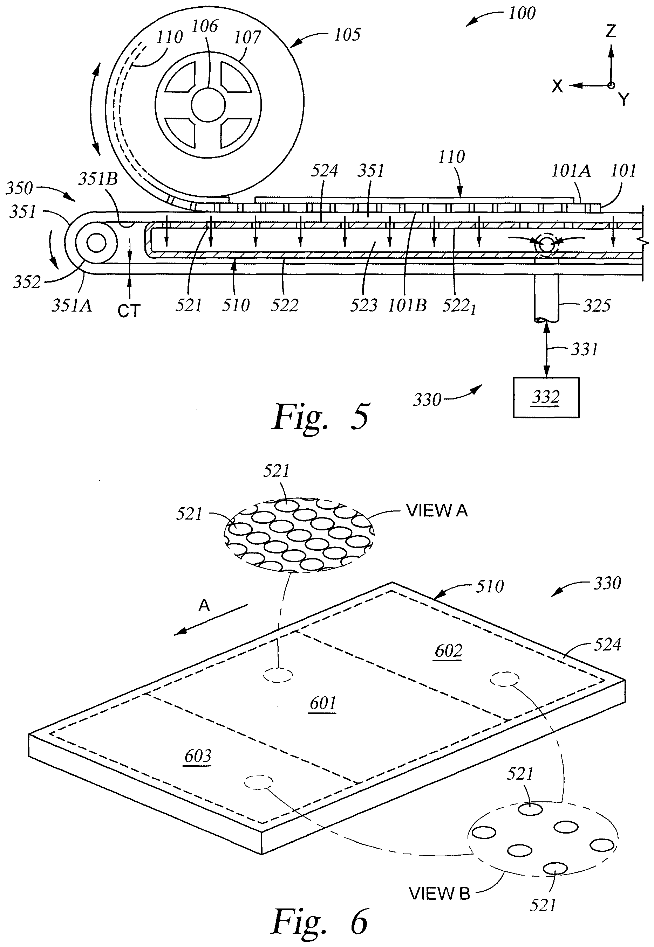

Referring to Figure 2, in some embodiments, a plurality of holes 202 are formed through the thickness T of the carrier film 101. The plurality of holes 202 are further configured to allow removal of water or other substances from a substantial portion of the surfaces 110A of the flexible photovoltaic sub-modules 110 that are in contact with the surface 101A of the carrier film 101. For example, the plurality of holes 202 can enable evacuation of air, gases, or humidity that are disposed within the carrier film 101 or on a surface of the flexible photovoltaic sub-modules 110 during storage between the photovoltaic module processing steps. Extended exposure to air, humidity or other environmental gases can damage the thin-film layers formed on the sub-modules 110. The plurality of holes 202 may also enable circulation and uniform distribution of a replacement gas, for example nitrogen, which may be used to protect the sub-modules 110 during their storage within the sub-module roll 105 in between the photovoltaic module processing steps. Furthermore, the plurality of holes 202 can extend to edges 115, 116 (Figure 1A) as well as ends 102, 103 of the first surface 101A and second surface 101B (Figure 5) of the carrier film 101 to allow removal of water or other substances from the carrier film 101 and surfaces 110A of the flexible sub-modules 110 when the flexible photovoltaic sub-modules 110 are stored (e.g., wound-up) within the sub-module roll 105. For example, when the carrier film 101 is entirely wound up in the sub-module roll 105, then the sub-module roll 105 may be placed in a vacuum compartment where the applied vacuum can remove water or other substances from portions of the carrier film 101, such as the outermost ring of the roll 105 and from either end of the roll 105, where the edges 115, 116 are exposed.

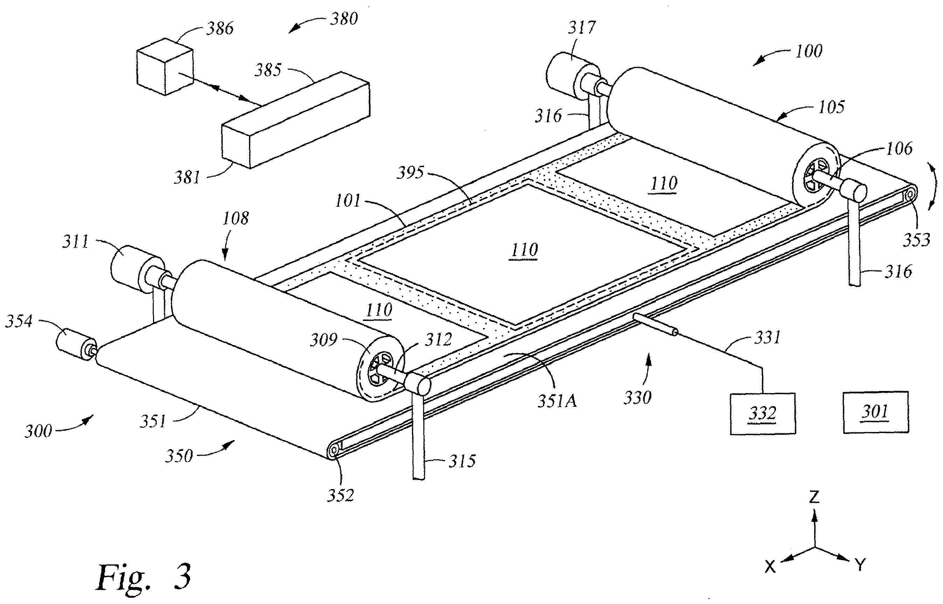

Figure 3 is an isometric view of a photovoltaic sub-module positioning device 300. The photovoltaic sub-module positioning device 300 includes a transport assembly 350 and the sub-module retaining assembly 100. The transport assembly 350 can be used to support and position the flexible photovoltaic sub-modules 110 and/or carrier film 101 disposed in the sub-module retaining assembly 100 in a desirable position, a desirable orientation, and a desirable flatness (e.g., undistorted), so that a sub-module transport assembly 380 can reliably remove flexible photovoltaic sub-modules 110 from, and/or place flexible photovoltaic sub-modules 110 on, the surface 101A of the carrier film 101. A person skilled in the art will note that while Figure 3 illustrates one sub-module 110 entirely exposed within the exposed receiving area 395 of the carrier film 101, it is possible to use the carrier film 101 to store and retrieve sub-modules that have an X-dimension that is greater than the X-dimension of the receiving area 395. In some embodiments, the exposed receiving area 395 may extend across the whole exposed area between the sub-module rolls 105, 108, such as the space between an inside edge of the first sub-module roll 105 and an inside edge of a second sub-module roll 108. In some embodiments, the receiving area 395 may alternately be large enough to accommodate a plurality of sub-modules 110.

The sub-module transport assembly 380 is generally adapted to transport a flexible photovoltaic sub-module 110 from the sub-module retaining assembly 100 to downstream photovoltaic module manufacturing equipment (not shown) and/or transfer a flexible photovoltaic sub-module 110 from upstream photovoltaic module manufacturing equipment (not shown) to the surface 101A of the carrier film 101 of the sub-module retaining assembly 100. In general, the sub-module transport assembly 380 includes a robotic device (not shown) that is attached to a moveable end-effector 385, which can have a receiving surface 381 that is at least as large as the light receiving surface of the flexible photovoltaic sub-module 110. The moveable end-effector 385 may also have one or more features formed thereon that is adapted to retain a flexible photovoltaic sub-module 110. In one example, the moveable end-effector 385 has a plurality of ports (not shown) formed therein that are in fluid communication with a vacuum source 386, so as to hold the flexible photovoltaic sub-modules 110 on the receiving surface 381 of the end-effector 385 during the sub-module transportation process. The moveable end-effector 385 may comprise a convex shape to enable a spatially progressive retrieval or release of at least one sub-module 110. The moveable end-effector 385 may comprise a compressible assembly, for example a foam or a padded surface, to alleviate contact forces during retrieval or release of at least one sub-module 110.

The transport assembly 350 generally includes a carrier belt 351 (e.g., porous carrier belt) that is supported by a plurality of rollers, such as rollers 352, 353, which are driven by an electrical or pneumatic actuator 354. A system controller 301 is used to control the movement of the carrier belt 351 and position of flexible photovoltaic sub-modules 110 on the carrier belt 351 during processing by controlling the output motion of the actuator 354. The carrier belt 351 may be formed from a durable porous material, which may have a plurality of holes or pores formed therethrough. In one example, the carrier belt 351 includes a porous polymeric material (e.g., polyester (PET) material) that has a thickness of from about 1mm to about 5mm. The carrier belt 351 may be formed from a woven or non-woven material. In one embodiment, the plurality of holes or pores are formed through a thickness CT (Figure 5) of the carrier belt 351 allowing a gas to pass through the thickness CT of the carrier belt 351.

The system controller 301 is generally used to facilitate the control and automation of the transport assembly 350 and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and related transport processes (e.g., sub-module position, process time, detector signal, etc.). The memory is connected to the CPU, and may be one or more of a readily available memory, such as flash memory, random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 301 determines which tasks are performable on the sub-module retaining assembly 100. For example, the program can be software readable by the system controller 301 including code to generate and store at least sub-module 110 positional information and the sequence of movements of the various controlled components.

In some configurations, as shown in Figure 3, portions of the sub-module retaining assembly 100 are disposed on the first sub-module roll 105, and other portions are disposed on the second sub-module roll 108. The second sub-module roll 108 can be formed when the second end 102 of the carrier film 101 is wound around a supporting hub 309, which may be similar to the supporting hub 107 described above. In some configurations, the supporting hub 309 may also contain an axle 312 that is disposed along the central axis of the supporting hub 309. In this case, the first sub-module roll 105 and the second sub-module roll 108 can be spaced a distance apart so as expose a portion of the surface 101A of the carrier film 101 and one or more flexible photovoltaic sub-modules 110 that are disposed thereon. The flexible photovoltaic sub-modules 110 need only be positioned in an exposed and unsupported position between the sub-module rolls when the components in the sub-module transport assembly 380 are ready to interact with the flexible photovoltaic sub-modules 110.

In one configuration, such as the configuration shown in Figure 3, the supporting elements 315 and 316, which are connected to the axles 106, 312 of the first and second sub-module rolls 105, 108, respectively, are configured to support the first and second sub-module rolls 105, 108 such that the rear surface 101B (Figure 5) (e.g., second surface) of the carrier film 101 is in contact with a first surface 351A of the carrier belt 351 during processing. Therefore, the sub-module retaining assembly 100 can be wound or unwound from either the first or second sub-module rolls 105, 108 due to the interaction of the surface 101B of carrier film 101 with the first surface 351A of the carrier belt 351. In some configurations, to enhance the interaction between the surface 101B of carrier film 101 with the first surface 351A of the carrier belt 351, the supporting elements 315 and 316 are biased (e.g., spring loaded) such that a portion of first and second sub-module rolls 105, 108 are pressed against the first surface 351A of the carrier belt 351.

In some embodiments, the winding and unwinding motion of the first and second sub-module rolls 105, 108 can be controlled by use of an optional first actuator 317 coupled to the axle 106 of the first sub-module roll 105 and/or an optional second actuator 311 coupled to the axle 312 of the second sub-module roll 108, respectively, which receive commands from the system controller 301. The first actuator 317 and/or second actuator 311 can be used to assure that the carrier film 101 and sub-modules 110 remain in a substantially taught and planar orientation during a winding and/or unwinding process by controlling the tension of the carrier film 101 between the first and second sub-module rolls 105, 108.

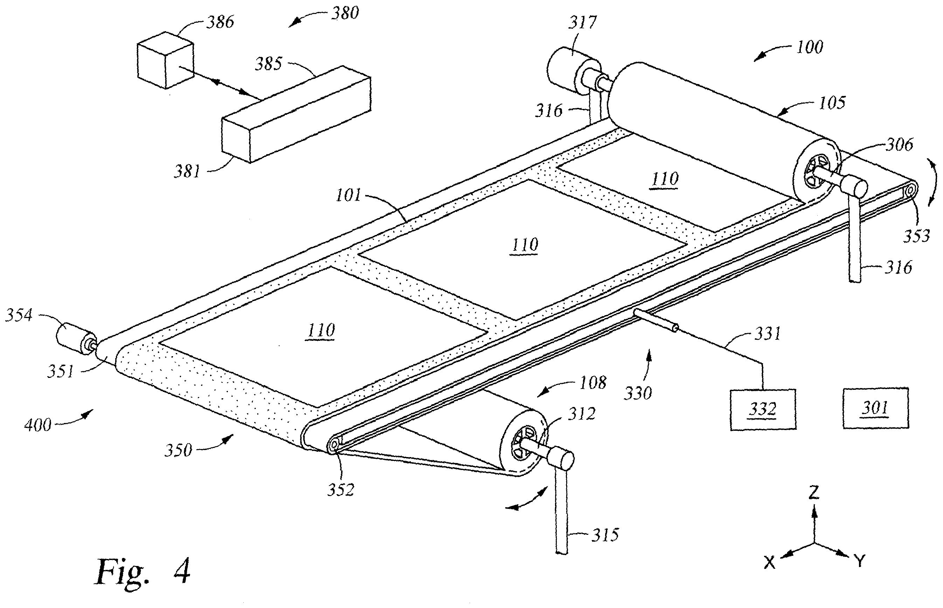

Figure 4 is an isometric view of a photovoltaic sub-module positioning device 400. The photovoltaic sub-module positioning device 400 includes an alternate configuration of the sub-module retaining assembly 100 that is disposed over the transport assembly 350. In this case, the second sub-module roll 108 and optional second actuator 311 are disposed in a position that allows the components in the sub-module transport assembly 380 unimpeded access to the surface 101A of the carrier film 101 or flexible photovoltaic sub-modules 110 disposed on the surface 101A of the carrier film 101. In one example, the components in the sub-module transport assembly 380 and system controller 301 are used to serially place flexible photovoltaic sub-modules 110 on the surface 101A of the carrier film 101 so that they can be wound-up in the sub-module roll 105 for storage. Alternatively, in one example, flexible photovoltaic sub-modules 110 that are disposed within the sub-module roll 105 are serially exposed by use of an unwinding motion of the sub-module roll 105 so that the components in the sub-module transport assembly 380 and system controller 301 can be used to serially remove the flexible photovoltaic sub-modules 110 from the surface 101A of the carrier film 101. However, the sub-module transport assembly 380 and system controller 301 can also be used to remove the flexible photovoltaic sub-modules 110 from the surface 101A of the carrier film 101 in a non-serial manner. In some cases, a serial or non-serial removal of a flexible photovoltaic sub-modules 110 from, or placement of flexible photovoltaic sub-modules 110 on, the surface 101A may be beneficial to reduce the number or length of a movement of one or more of the components found in the sub-module transport assembly 380 or transport assembly 350.

In some embodiments, as illustrated in Figures 3, 4 and 5, the transport assembly 350 may further include a vacuum distribution system 330 that is adapted to assure that the flexible photovoltaic sub-modules 110 and carrier film 101 that are in an exposed position between the first sub-module roll 105 and the second sub-module roll 108 will be retained in a substantially flat and planar orientation. Retaining the flexible photovoltaic sub-modules 110 and carrier film 101 in a substantially flat and planar orientation can prevent the uncontrolled distortion, for example the curl-up, of the flexible photovoltaic sub-modules 110 and improve the reliability of the transfer of the flexible photovoltaic sub-modules 110 from the surface 101A to the moveable end-effector 385 of the sub-module transport assembly 380. The vacuum distribution system 330 generally includes a vacuum support 510 (Figure 5) and a vacuum source 332 that is coupled to a port 325 (Figure 5) of the vacuum support 510 via a fluid connection 331.

Referring to Figure 5, in one embodiment, the vacuum support 510 includes one or more walls 522 that are configured to form an internal plenum 523, wherein one of the one or more walls 522, referred to herein as the first wall 522₁ has a surface 524 that is adapted to support a portion of the carrier belt 351 and the sub-module retaining assembly 100 during processing. For example, the surface 524 is shown contacting a second surface 351B of the carrier belt 351. As illustrated in Figure 5, the first wall 522₁ further includes a plurality of ports 521 that are in fluid communication with the vacuum source 332 though the plenum 523 and the fluid connection 331. In one embodiment, the carrier belt 351 is a porous material that allows the flexible photovoltaic sub-modules 110 and the carrier film 101, which is disposed on one side of the carrier belt 351, to be retained against the substantially planar surface 524 of the first wall 522₁ by a vacuum applied to the opposing side of the carrier belt 351 and the carrier film 101 by the vacuum source 332 (e.g., vacuum pump, vacuum ejector).

In one embodiment, a vacuum is applied to vacuum ports 521 formed in the first wall 522₁ so that the flexible photovoltaic sub-modules 110 can be retained on the supporting surface 524 of the first wall 522₁. As noted above, the carrier belt 351 and carrier film 101 can be made from a porous material that allows air to be evacuated in the space formed between the rear surface of the flexible photovoltaic sub-modules 110 and the surface 524 of the first wall 522₁. Therefore, due to the application of vacuum pressure to the rear surface of the flexible photovoltaic sub-modules 110 by the vacuum source 332, the flexible photovoltaic sub-modules 110 disposed over the first wall 522₁ can be retained in a shape that conforms to the shape of the surface 524 of the first wall 522₁. In one example, the shape of the surface 524 of the first wall 522₁ is substantially flat. In another example, the shape of the surface 524 of the first wall is substantially convex or substantially concave in a shape to prevent the vacuum generated retaining force from damaging one or more layers in the flexible photovoltaic sub-module 110 as the flexible photovoltaic sub-module 110 is forced to take the shape of the surface 524 during the retention process.

During processing, a vacuum pressure may be applied to the plenum 523, ports 521, carrier belt 351 and carrier film 101 continually or in an intermittent fashion by use of commands sent from the system controller 301 to valves (not shown) connected to the fluid connection 331 or vacuum source 332. In the continually generated vacuum case, the force applied to carrier belt 351, carrier film 101 and flexible photovoltaic sub-modules 110 by the generated vacuum can be adjusted to a level such that the generated force is not enough to prevent relative motion between the first wall and the carrier belt 351 and/or carrier film 101 due to a force applied by one of the actuators. In the intermittent case, the generation of the vacuum pressure in the plenum 523 may be adjusted, reduced, or halted while the transport assembly 350 is used to position one or more of the flexible photovoltaic sub-modules 110 and carrier film 101 over at least a portion of the first wall of the vacuum support 510.

Furthermore, the suction causing the vacuum pressure in the plenum 523 may be regulated by the system controller 301 as a function of whether the sub-modules 110 are present on the carrier film 101 or position of the sub-modules 110 above the first wall 522₁ when it is desirable for the sub-modules 110 to be subjected to a clamping force due to the generation of the vacuum pressure. For example, regulation of vacuum pressure may be function of: the dimensions of the sub-modules 110; the total area of the surface 524 that is covered by sub-modules 110; and the type of sub-modules 110. In some cases, a small sub-module 110, because of its aerodynamic and elastic properties, may require more force to clamp down. In other cases, a near complete coverage of the surface 101A by a sub-module 110 may require less suction than a sub-module 110 that only partially covers the surface 101A, because the near complete coverage of the sub-module 110 will tends to restrict some of the airflow to the underlying plenum 523 while a configuration that only partially covers the surface 101A will not provide as much restriction. Moreover, sub-modules 110 that are only coated with the conductive layer 120 may exhibit a stronger tendency to curl up versus completed photovoltaic sub-modules 110 (e.g., sub-modules containing layers 120-160 shown in Figure 1B), and thus may require more force to clamp down.

Once the flexible photovoltaic sub-modules 110 and carrier film 101 are desirably positioned over the first wall 522₁, a vacuum pressure may be generated in the plenum 523 so that a retaining force can be applied to the flexible photovoltaic sub-modules 110 and carrier film 101. Alternatively, in some embodiments, the amount of vacuum pressure generated in the plenum 523 may be at a first pressure when the flexible photovoltaic sub-modules 110, carrier film 101 and carrier belt 351 are in motion relative to the surface 524 and a second pressure when the flexible photovoltaic sub-modules 110, carrier film 101 and carrier belt 351 are not in motion. In one example, the first pressure may be at a lower vacuum pressure (e.g., greater absolute pressure) than the second pressure. In this case, the first pressure may be near atmospheric pressure (e.g., 750 Torr) and the second pressure may be at a lower vacuum pressure (e.g., 25 Torr). However, a person skilled in the art will take into consideration that it is the suction at the interface between the carrier film 101 and the sub-modules 110 that is useful to ensure flatness of the portion of the sub-modules 110 that enter the sub-module rolls 105, 108 upon winding of the carrier film 101. For example, for storage of polyimide-based flexible photovoltaic sub-modules 110, the pressure at the surface of the carrier film 101 can be in a range from 3 Pascals (Pa) to 300 Pa, such as from 7 Pa to 200 Pa, or even from 20 Pa to 120 Pa below ambient atmospheric pressure. A person skilled in the art will appreciate that higher suction pressures are generally helpful to flatten the sub-modules 110, and may also hinder the introduction of waves in the sub-module 110 due to the mechanical deformation of the sub-modules 110 as they are laid down on the carrier film 101 or wound into the sub-module roll 105, and therefore reduce the risk of forming wrinkles.

The pressure used at the surface 524 of the plenum 523 is necessarily lower (e.g., larger vacuum pressure) than at the surface 101A of the carrier film 101, because the pressure at the surface 101A is influenced by leakages at the interfaces between the plenum's surface and the carrier belt 351, between the carrier belt 351 and the carrier film 101, and possibly also at the edges of the carrier belt 351 and edges of the carrier film 101. An initial estimate for the required drop in pressure with respect to atmospheric pressure at the surface 524 of the plenum 523 to be used is that the pressure drop may need to be in a range from about 1.2 to about 3.0 times, such as about 1.7 times the values mentioned for the ranges of pressures below atmospheric pressure at the surface 101A of the carrier film 101.

Figure 6 is an isometric view of the surface 524 of the first wall 522₁ of the vacuum support 510, according to an embodiment of the disclosure provided herein. In general, the first wall 522₁ may have a plurality of ports 521 formed therethrough, which are formed in a desirable density and pattern. In one example, as illustrated in Figure 6, the ports 521 are formed in a pattern that has at least two regions that have a different density of ports 521 formed through the surface 524 of the first wall 522₁. In one case, the density of ports 521 (see View A) in a central region 601 is greater than the density of ports 521 in at least one of the outer regions 602, 603 (see View B). In this case, it is believed that the higher density of ports 521 will increase the holding force applied to the flexible photovoltaic sub-modules 110, carrier film 101 and carrier belt 351 in the central region 601 versus an outer region 602, 603, when a vacuum pressure is generated in the plenum 523 by the vacuum source 332. Therefore, in regions where it is important to assure that the sub-module 110 is retained for transportation by the sub-module transport assembly 380, the density of holes may be higher than for other regions of the first wall 522₁. In one configuration, as a sub-module 110 is transferred across the surface 524 of the vacuum support 510 in a direction A, a force applied by the generated vacuum to the sub-module 110 may vary. In one example, as shown in Figure 6, the net force applied to a sub-module 110 that is transferred across the surface 524 in the direction A will increase as the sub-module 110 moves from outer region 602 to central region 601 and then decrease as it moves from central region 601 to outer region 603.

Therefore, by use of the sub-module retaining assembly 100 and the transport assembly 350 described above, one or more sub-modules 110 can be easily positioned, supported and/or retained so that they can be reliably transferred from or positioned within the sub-module retaining assembly 100 during different phases of the photovoltaic module formation process.

As noted above, the flexible photovoltaic sub-modules 110 may be arranged in any desired pattern and/or orientation on the surface 101A of a carrier film 101 within the sub-module retaining assembly 100. In some cases, flexible photovoltaic sub-modules 110 having different sizes and shapes may be disposed and arranged on the surface 101A of a carrier film 101, and thus a single sub-module roll 105 within the sub-module retaining assembly 100 can be used to support, retain and transport an assortment of flexible photovoltaic sub-modules 110 to a desired end-user or to a desired portion of a photovoltaic module production line. Furthermore, the sub-module retaining assembly 100 can be used to support, retain and transport an assortment of flexible photovoltaic sub-modules 110 and other devices, for example pre-cut foils useful for encapsulation of flexible photovoltaic sub-modules 110.

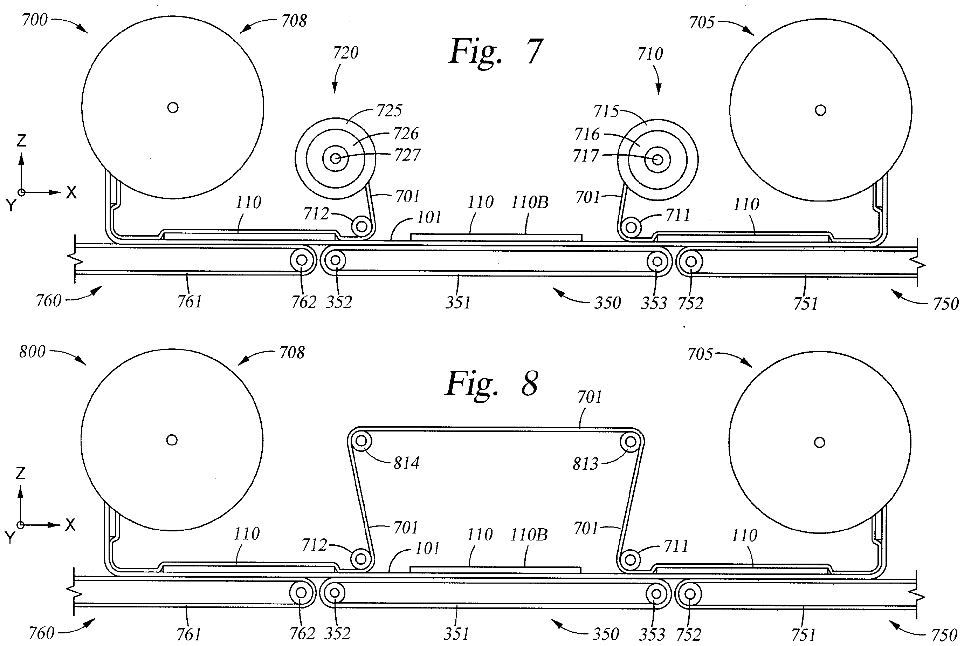

Figure 7 is a side cross-sectional view of a photovoltaic sub-module positioning device 700, according to another embodiment of the present disclosure. The photovoltaic sub-module positioning device 700 includes the transport assembly 350 that includes the carrier belt 351 supported by the rollers 352, 353 as described above. The photovoltaic sub-module positioning device 700 further includes a first sub-module roll 705 and a second sub-module roll 708. The first sub-module roll 705 is the same as the first sub-module roll 105 described above, except that the first sub-module roll 705 additionally includes an interleave layer 701. Similarly, the second sub-module roll 708 is the same as the second sub-module roll 108 described above, except that the second sub-module roll 708 also additionally includes the interleave layer 701. The interleave layer 701 is used to support and/or prevent the flexible photovoltaic sub-modules 110 from adhering to or becoming damaged by contact with the carrier film 101. The interleave layer 701 can be formed of a polymeric film (e.g., a polyethylene terephthalate film), paper or a paper-based material. The interleave layer 701 is disposed between the flexible photovoltaic sub-modules 110 and the carrier film 101 in the sub-module rolls 705, 708.

The first sub-module roll 705 is disposed above a payout transport assembly 750. The payout transport assembly 750 includes a carrier belt 751 disposed around a plurality of rollers, such as the roller 752. The payout transport assembly 750 assists in unwinding the first sub-module roll 705, so that the flexible photovoltaic sub-modules 110 delivered from the first sub-module roll 705 can be provided to the transport assembly 350. The carrier belt 751 may be driven by an actuator (not shown). In some embodiments, a passive conveyor, such as a series of free-spinning rollers, may be used instead of the carrier belt 751.

The second sub-module roll 708 is disposed above a pickup transport assembly 760. The pickup transport assembly 760 includes a carrier belt 761 disposed around a plurality of rollers, such as the roller 762. The pickup transport assembly 760 assists in winding the carrier film 101, flexible photovoltaic sub-modules 110, and interleave layer 701 into the second sub-module roll 708. The carrier belt 761 may be driven by an actuator (not shown). In some embodiments, a passive conveyor, such as a series of free-spinning rollers, may be used instead of the carrier belt 761.

The photovoltaic sub-module positioning device 700 further includes an interleave pickup assembly 710 configured to separate the interleave layer 701 from a given section of the carrier film 101 including at least one flexible photovoltaic sub-module 110 after the given section of the carrier film 101 is unwound from the first sub-module roll 705. The interleave pickup assembly 710 can include a pickup roll 715 disposed around a hub 716 that is coupled to an axle 717. The axle 717 can be coupled to an actuator (not shown) in some embodiments to rotate the interleave pickup assembly 710 and facilitate the winding of the interleave layer 701 into the pickup roll 715. The interleave pickup assembly 710 separates the interleave layer 701 from the flexible photovoltaic sub-module 110 with assistance from a first interleave roller 711, so that the flexible photovoltaic sub-modules 110 can be exposed for processing on the transport assembly 350. The interleave layer 701 is wrapped around the first interleave roller 711 and wound into pickup roll 715. The first interleave roller 711 is disposed at a vertical location in the Z-direction between the interleave pickup assembly 710 and the carrier belt 351. In some embodiments, separating the interleave layer 701 from the carrier film 101 allows for one or more flexible photovoltaic sub-modules 110 to be positioned on the portions of the carrier film 101 disposed on the transport assembly 350, for example using the sub-module transport assembly 380 described above.

The photovoltaic sub-module positioning device 700 further includes an interleave payout assembly 720 configured to place the interleave layer 701 over a given section of the carrier film 101 including at least one flexible photovoltaic sub-module 110 before the given section of the carrier film 101 is wound into the second sub-module roll 708. The interleave payout assembly 720 can include a payout roll 725 disposed around a hub 726 that is coupled to an axle 727. The axle 727 can be coupled to an actuator (not shown) in some embodiments to rotate the interleave payout assembly 720 and facilitate the unwinding of the interleave layer 701 from the payout roll 725. A second interleave roller 712 can be disposed at a vertical location in the Z-direction between the interleave payout assembly 720 and the carrier belt 351 to ease the transfer of the interleave layer 701 onto the flexible photovoltaic sub-modules 110 and the carrier film 101. The interleave payout assembly 720 places the interleave layer 701 over the flexible photovoltaic sub-modules 110 before the flexible photovoltaic sub-modules 110 are wound into the second sub-module roll 708 in order to support and/or protect the flexible photovoltaic sub-modules 110 from potential mechanical damage caused by the interaction with the carrier film 101 during the wind-up of these components in the second sub-module roll 708. Using the interleave pickup assembly 710 and the interleave payout assembly 720 allows unimpeded access to the flexible photovoltaic sub-modules 110 disposed on the carrier belt 351 of the transport assembly 350 because there is no equipment above the flexible photovoltaic sub-modules 110 when the flexible photovoltaic sub-modules 110 are disposed over a central area of the first wall 522₁ (Figure 5), such as central region 601 (Figure 6).

Figure 8 is a side cross-sectional view of a photovoltaic sub-module positioning device 800, according to another embodiment of the present disclosure. The photovoltaic sub-module positioning device 800 is similar to the photovoltaic sub-module positioning device 700 except that the photovoltaic sub-module positioning device 800 includes a third interleave roller 813 instead of the interleave pickup assembly 710 and also includes a fourth interleave roller 814 instead of the interleave payout assembly 720. Furthermore, the photovoltaic sub-module positioning device 800 only uses one length of interleave layer 701 material instead of the two separate rolls of interleave layer 701 (i.e., pickup roll 715 and payout roll 725) material that were used in the photovoltaic sub-module positioning device 700. The third interleave roller 813 and the fourth interleave roller 814 can be disposed above carrier belt 351 at a similar vertical location in the Z-direction. This vertical location can be set high enough, so that the portion of the interleave layer 701 disposed above the interleave rollers 813, 814 does not interfere with access to the flexible photovoltaic sub-modules 110 disposed on the carrier belt 351.

The third interleave roller 813 is disposed closer to the payout transport assembly 750 in the X-direction than the third interleave roller 813 is to the pickup transport assembly 760 in the X-direction. The fourth interleave roller 814 is disposed closer to the pickup transport assembly 760 in the X-direction than the fourth interleave roller 814 is to the payout transport assembly 750 in the X-direction. By using the interleave rollers 813, 814 instead of the interleave pickup assembly 710 and the interleave payout assembly 720, less equipment can be used reducing the capital costs and operating costs of the photovoltaic sub-module positioning device 800 relative to the photovoltaic sub-module positioning device 700.

While the foregoing is directed to embodiments of the present disclosure, other and further embodiments of the disclosure may be devised without departing from the basic scope thereof, and the scope thereof is determined by the claims that follow.

## Claims

1. A photovoltaic sub-module retaining assembly (100), comprising:
a porous carrier film (101) ;
one or more flexible photovoltaic sub-modules (110) disposed on a first surface (101A) of the porous carrier film, wherein at least one of the one or more flexible photovoltaic sub-modules is supported by a portion of the porous carrier film that is wound around a central axis (106) to form a roll (105);
and an interleave layer (701) disposed over the porous carrier film and over at least one of the one or more flexible photovoltaic sub-modules;
wherein the porous carrier film (101) further comprises:
a second surface (101B) that is opposite to the first surface (101A) ;
a thickness (T) that is defined between the first surface and the second surface; and
a plurality of holes (202) that provide a path from the first surface to the second surface through the thickness, wherein a surface of the one or more flexible photovoltaic sub-modules is in contact with the first surface of the carrier film (101) .

2. The photovoltaic sub-module retaining assembly of claim 1, wherein the one or more flexible photovoltaic sub-modules comprises two or more flexible photovoltaic sub-modules.

3. The photovoltaic sub-module retaining assembly of any of the preceding claims, further comprising a supporting hub (107) around which the porous carrier film and the one or more flexible photovoltaic sub-modules are wound, wherein the supporting hub has a diameter of at least 15 mm.

4. The photovoltaic sub-module retaining assembly of any of the preceding claims, wherein the porous carrier film further comprises a moisture getter.

5. A photovoltaic sub-module positioning device (300), comprising:
a flexible photovoltaic sub-module retaining assembly (100) according to claim 1;
a transport assembly (350) that comprises:
a porous carrier belt (351) having a first surface (351A), wherein the first surface of the porous carrier belt is in contact with a portion of the second surface (101B) of the porous carrier film;
a first plurality of rollers (352, 353) that are configured to support the porous carrier belt;
an actuator (354) that is configured to cause the porous carrier belt to translate in a first direction relative to a position of one of the first plurality of rollers; and
a controller (301) that is configured to control a movement of the porous carrier belt by use of commands sent to the actuator.

6. The photovoltaic sub-module positioning device of claim 5, further comprising:
a vacuum support (510) having a first wall (522₁) having a surface contacting a second surface of the porous carrier belt, wherein the first wall has a plurality of ports (521) that are in fluid communication with a vacuum source (332),
wherein the vacuum source is adapted to generate a force that causes at least one of the one or more flexible photovoltaic sub-modules, a portion of the porous carrier film, and a portion of the porous carrier belt to be retained on the surface of the first wall.

7. The photovoltaic sub-module positioning device of claim 6, wherein the controller (301) is configured to adjust the force based on a position of one or more of the flexible photovoltaic sub-modules above the first wall.

8. The photovoltaic sub-module positioning device of claim 6, wherein the controller is configured to adjust the force based on whether the carrier belt is in motion relative to the surface.

9. The photovoltaic sub-module positioning device of any of the claims 6 to 8, wherein:
the first wall includes a first region and a second region;
the first region has a first density of the ports;
second region a second density of the ports; and
the first density is greater than the second density.

10. The photovoltaic sub-module positioning device of any of the claims 5 to 9, wherein the porous carrier film extends over the porous carrier belt from the roll to a second roll and a second portion of the porous carrier film is included in the second roll and the second roll is disposed below the porous carrier belt.

11. The photovoltaic sub-module positioning device of any of the claims 5 to 10, further comprising an interleave pickup assembly (710) configured to separate the interleave layer from a section of the carrier film including at least one flexible photovoltaic sub-module after the section of the carrier film is unwound from the roll.

12. The photovoltaic sub-module positioning device of any of the claims 10 to 11, further comprising an interleave payout assembly (720) configured to place the interleave layer over a section of the carrier film including at least one flexible photovoltaic sub-module before the section of the carrier film is wound into the second roll.

13. The photovoltaic sub-module positioning device of any of the claims 5 to 12, further comprising a second plurality of rollers positioned above the porous carrier belt, wherein the interleave layer is separated from the flexible photovoltaic sub-modules and the carrier film by positioning the interleave layer over the second plurality of rollers.

14. The photovoltaic sub-module positioning device of any of the claims 5 to 13, further comprising a supporting hub (107) around which the porous carrier film and the one or more flexible photovoltaic sub-modules are wound, wherein the supporting hub has a diameter of at least 15 mm.

## Patentansprüche

1. Photovoltaik-Submodul-Halteanordnung (100), umfassend:
einen porösen Trägerfilm (101);
ein oder mehrere flexible Photovoltaik-Submodule (110), die auf einer ersten Oberfläche (101A) der porösen Trägerfolie angeordnet sind, wobei mindestens eines der einen oder mehreren flexiblen Photovoltaik-Submodule von einem Abschnitt der porösen Trägerfolie getragen wird, der um eine Mittelachse (106) gewickelt ist, um eine Rolle (105) zu bilden;
und eine Zwischenschicht (701), die über dem porösen Trägerfilm und über mindestens einem der ein oder mehreren flexiblen Photovoltaik-Submodule angeordnet ist;
wobei der poröse Trägerfilm (101) ferner umfasst:
eine zweite Oberfläche (101B), die der ersten Oberfläche (101A) gegenüberliegt;
eine Dicke (T), die zwischen der ersten Oberfläche und der zweiten Oberfläche definiert ist; und
eine Vielzahl von Löchern (202), die einen Weg von der ersten Oberfläche zur zweiten Oberfläche durch die Dicke bereitstellen, wobei eine Oberfläche des einen oder der mehreren flexiblen Photovoltaik-Submodule mit der ersten Oberfläche der Trägerfolie (101) in Kontakt steht.

2. Halteanordnung für das Photovoltaik-Submodul nach Anspruch 1, worin das eine oder die mehreren flexiblen Photovoltaik-Submodule zwei oder mehrere flexible Photovoltaik-Submodule umfassen.

3. Photovoltaik-Submodul-Halteanordnung nach einem der vorhergehenden Ansprüche, ferner umfassend eine Stützhub (107), um den der poröse Trägerfilm und das eine oder die mehreren flexiblen Photovoltaik-Submodule gewickelt sind, wobei die Stützhub einen Durchmesser von mindestens 15 mm aufweist.

4. Photovoltaik-Submodul-Halteanordnung nach einem der vorhergehenden Ansprüche, worin der poröse Trägerfilm ferner einen Feuchtigkeitsgetter umfasst.

5. Positionierungsvorrichtung (300) für ein photovoltaisches Submodul, umfassend:
eine flexible Photovoltaik-Submodul-Halteanordnung (100) nach Anspruch 1;
eine Transportanordnung (350), die umfasst:
ein poröses Trägerband (351) mit einer ersten Oberfläche (351A), wobei die erste Oberfläche des porösen Trägerbandes in Kontakt mit einem Abschnitt der zweiten Oberfläche (101B) des porösen Trägerfilms steht;
eine erste Vielzahl von Rollen (352, 353), die konfiguriert sind, um das poröse Trägerband zu tragen;
ein Stellglied (354), das konfiguriert ist, um zu bewirken, dass sich das poröse Trägerband in eine erste Richtung relativ zu einer Position einer der ersten Vielzahl von Rollen verschiebt; und
eine Steuerung (301), die konfiguriert ist, um eine Bewegung des porösen Trägerbandes unter Verwendung von Befehlen, die an das Stellglied gesendet werden, zu steuern.

6. Positionierungsvorrichtung für ein photovoltaisches Submodul nach Anspruch 5, ferner umfassend:
einen Vakuumträger (510) mit einer ersten Wand (522₁) mit einer Oberfläche, die eine zweite Oberfläche des porösen Trägerbandes berührt, wobei die erste Wand eine Vielzahl von Öffnungen (521) aufweist, die in Fluidverbindung mit einer Vakuumquelle (332) stehen,
wobei die Vakuumquelle angepasst ist, um eine Kraft zu erzeugen, die bewirkt, dass mindestens eines der einen oder mehreren flexiblen Photovoltaik-Submodule, ein Teil des porösen Trägerfilms und ein Teil des porösen Trägerbandes auf der Oberfläche der ersten Wand gehalten werden.

7. Positionierungsvorrichtung für ein Photovoltaik-Submodul nach Anspruch 6, wobei die Steuerung (301) konfiguriert ist, um die Kraft basierend auf einer Position eines oder mehrerer der flexiblen Photovoltaik-Submodule oberhalb der ersten Wand einzustellen.

8. Positionierungsvorrichtung für das photovoltaische Submodul nach Anspruch 6, wobei die Steuerung konfiguriert ist, um die Kraft basierend darauf einzustellen, ob das Trägerband in Bewegung ist, bezogen auf die Oberfläche.

9. Positionierungsvorrichtung für ein photovoltaisches Submodul nach einem der Ansprüche 6 bis 8, wobei:
die erste Wand einen ersten Bereich und einen zweiten Bereich beinhaltet;
der erste Bereich eine erste Dichte der Öffnungen aufweist;
zweiten Bereich eine zweite Dichte der Öffnungen; und
die erste Dichte ist größer als die zweite Dichte.

10. Photovoltaik-Submodul-Positionierungsvorrichtung nach einem der Ansprüche 5 bis 9, worin sich der poröse Trägerfilm über das poröse Trägerband von der Rolle zu einer zweiten Rolle erstreckt und ein zweiter Abschnitt des porösen Trägerfilms in der zweiten Rolle enthalten ist und die zweite Rolle unter dem porösen Trägerband angeordnet ist.

11. Positionierungsvorrichtung für ein Photovoltaik-Submodul nach einem der Ansprüche 5 bis 10, ferner umfassend eine Zwischenschicht -Aufnahmeanordnung (710), die konfiguriert ist, um die Zwischenschicht von einem Abschnitt der Trägerfolie zu trennen, die mindestens ein flexibles Photovoltaik-Submodul beinhaltet, nachdem der Abschnitt der Trägerfolie von der Rolle abgewickelt wurde.

12. Positionierungsvorrichtung für ein Photovoltaik-Submodul nach einem der Ansprüche 10 bis 11, ferner umfassend eine Zwischenschicht -Auszahlungsanordnung (720), die konfiguriert ist, um die Zwischenschicht über einem Abschnitt der Trägerfolie mit mindestens einem flexiblen Photovoltaik-Submodul zu platzieren, bevor der Abschnitt der Trägerfolie in die zweite Rolle gewickelt wird.

13. Photovoltaik-Submodul-Positionierungsvorrichtung nach einem der Ansprüche 5 bis 12, ferner umfassend eine zweite Vielzahl von Rollen, die über dem porösen Trägerband angeordnet sind, worin die Zwischenschicht von den flexiblen Photovoltaik-Submodulen und dem Trägerfilm getrennt ist, indem die Zwischenschicht über der zweiten Vielzahl von Rollen positioniert wird.

14. Positionierungsvorrichtung für ein Photovoltaik-Submodul nach einem der Ansprüche 5 bis 13, ferner umfassend eine Stütznabe (107), um die der poröse Trägerfilm und das eine oder die mehreren flexiblen Photovoltaik-Submodule gewickelt sind, wobei die Stütznabe einen Durchmesser von mindestens 15 mm aufweist.

## Revendications

1. Dispositif de retenue de sous-module photovoltaïque (100), comprenant :
un film porteur poreux (101) ;
un ou plusieurs sous-modules photovoltaïques flexibles (110) disposés sur une première surface (101A) du film de support poreux, dans lequel au moins un des sous-modules photovoltaïques flexibles est supporté par une partie du film de support poreux qui est enroulée autour d'un axe central (106) pour former un rouleau (105) ;
et une couche intercalaire (701) disposée sur le film de support poreux et sur au moins l'un des un ou plusieurs sous-modules photovoltaïques flexibles ;
où le film de support poreux (101) comprend en outre :
une deuxième surface (101B) qui est opposée à la première surface (101A) ;
une épaisseur (T) qui est définie entre la première surface et la deuxième surface ; et
une pluralité de trous (202) qui fournissent une communication de la première surface à la deuxième surface à travers l'épaisseur, où une surface des un ou plusieurs sous-modules photovoltaïques flexibles est en contact avec la première surface du film de support (101).

2. Dispositif de retenue de sous-module photovoltaïque selon la revendication 1, dans lequel l'un des un ou plusieurs sous-module(s) photovoltaïque(s) flexible(s) comprend (comprennent) deux ou plusieurs sous-modules photovoltaïques flexibles.

3. Dispositif de retenue de sous-module photovoltaïque de l'une quelconque des revendications précédentes, comprenant en outre un moyeu de support (107) autour duquel le film porteur poreux et un ou plusieurs sous-modules photovoltaïques flexibles sont enroulés, où le moyeu de support a un diamètre d'au moins 15 mm.

4. Dispositif de retenue de sous-module photovoltaïque de l'une quelconque des revendications précédentes, dans lequel le film de support poreux comprend en outre un adsorbant d'humidité.

5. Dispositif de positionnement de sous-module photovoltaïque (300), comprenant :
un dispositif de retenue de sous-module photovoltaïque flexible (100) selon la revendication 1 ;
un dispositif de transport (350) qui comprend :
une bande porteuse poreuse (351) ayant une première surface (351A), dans laquelle la première surface de la bande porteuse poreuse est en contact avec une partie de la seconde surface (101B) du film porteur poreux ;
une première pluralité de rouleaux (352, 353) qui sont configurés pour supporter la courroie porteuse poreuse ;
un actionneur (354) qui est configuré pour amener la courroie porteuse poreuse à se déplacer dans une première direction par rapport à une position de l'un de la première pluralité de rouleaux ; et
un contrôleur (301) qui est configuré pour commander un mouvement de la courroie porteuse poreuse en utilisant des commandes envoyées à l'actionneur.

6. Dispositif de positionnement de sous-module photovoltaïque selon la revendication 5, comprenant en outre :
un support à vide (510) ayant une première paroi (522₁) ayant une surface en contact avec une seconde surface de la bande porteuse poreuse, dans lequel la première paroi a une pluralité d'orifices (521) qui sont en communication fluide avec une source de vide (332),
dans laquelle la source de vide est adaptée pour générer une force qui provoque le maintien d'au moins l'un des un ou plusieurs sous-modules photovoltaïques flexibles, d'une partie du film porteur poreux et d'une partie de la bande porteuse poreuse à la surface de la première paroi.

7. Dispositif de positionnement de sous-module photovoltaïque selon la revendication 6, dans lequel le régulateur (301) est configuré pour régler la force en fonction d'une position d'un ou plusieurs des sous-module(s) photovoltaïque(s) flexible(s) au-dessus de la première paroi.

8. Dispositif de positionnement de sous-module photovoltaïque selon la revendication 6, dans lequel le régulateur est configuré pour régler la force en fonction du fait que la bande porteuse est en mouvement par rapport à la surface.

9. Dispositif de positionnement de sous-module photovoltaïque de l'une quelconque des revendications 6 à 8, dans lequel :
la première paroi comprend une première région et une deuxième région ;
la première région a une première densité des ports ;
la deuxième région une deuxième densité des ports ; et
la première densité est supérieure à la seconde.

10. Dispositif de positionnement de sous-module photovoltaïque de l'une quelconque des revendications 5 à 9, dans lequel le film de support poreux s'étend sur la bande de support poreuse du rouleau à un deuxième rouleau et une deuxième partie du film de support poreux est incluse dans le deuxième rouleau et le deuxième rouleau est disposé sous la bande de support poreux.

11. Dispositif de positionnement de sous-module photovoltaïque de l'une quelconque des revendications 5 à 10, comprenant en outre un dispositif collecteur de la couche intercalaire (710) configuré pour séparer la couche intercalaire d'une section du film de support comprenant au moins un sous-module photovoltaïque flexible après que la section du film de support est déroulée du rouleau.

12. Dispositif de positionnement de sous-module photovoltaïque de l'une quelconque des revendications 10 à 11, comprenant en outre un dispositif pour déployer la couche intercalaire (720) configuré pour placer la couche intercalaire sur une section du film de support comprenant au moins un sous-module photovoltaïque flexible avant que la section du film support soit enroulée dans le second rouleau.

13. Dispositif de positionnement de sous-module photovoltaïque de l'une quelconque des revendications 5 à 12, comprenant en outre une seconde pluralité de rouleaux positionnés au-dessus de la bande porteuse poreuse, dans lequel la couche intercalaire est séparée des sous-modules photovoltaïques flexibles et du film porteur en positionnant la couche intercalaire sur la seconde pluralité de rouleaux.

14. Dispositif de positionnement de sous-module photovoltaïque de l'une quelconque des revendications 5 à 13, comprenant en outre un moyeu de support (107) autour duquel le film porteur poreux et les sous-module(s) photovoltaïque(s) flexible(s) sont enroulés, dans lequel le moyeu de support a un diamètre d'au moins 15 mm.
